# EUROPÄISCHE PATENTSCHRIFT

(11) **EP 0 746 800 B1**
(45) Veröffentlichungstag und Bekanntmachung des Hinweises auf die Patenterteilung: **10.10.2001**
(21) Anmeldenummer: 95909763.5
(22) Anmeldetag: 21.02.1995
(51) Int. Cl.: G03F 7/20

(54) **VERFAHREN UND VORRICHTUNG ZUR PHOTOMECHANISCHEN HERSTELLUNG STRUKTURIERTER OBERFLÄCHEN, INSBESONDERE ZUM BELICHTEN VON OFFSETDRUCKPLATTEN**
PROCESS AND DEVICE FOR THE PHOTOMECHANICAL PRODUCTION OF STRUCTURED SURFACES, IN PARTICULAR FOR EXPOSING OFFSET PLATES
PROCEDE ET DISPOSITIF DE PRODUCTION PHOTOMECANIQUE DE SURFACES STRUCTUREES, PLUS PARTICULIEREMENT POUR L'EXPOSITION A LA LUMIERE DE PLAQUES OFFSET

(30) Priorität: 21.02.1994 DE 4405888
(43) Veröffentlichungstag der Anmeldung: 11.12.1996
(73) Patentinhaber: Lüllau, Friedrich, 21357 Bardowick (DE)
(72) Erfinder: LÜLLAU, Friedrich, D-21357 Bardowick (DE); MAYER, Claus, D-21391 Reppenstedt (DE); LÜLLAU, Rolf, D-21365 Adendorf (DE)
(74) Vertreter: Vonnemann, Gerhard, Dr.-Ing.
(86) Internationale Anmeldenummer: EP9500632
(87) Internationale Veröffentlichungsnummer: WO9522787

(56) Entgegenhaltungen:
- EP-A- 0 253 129
- WO-A-91/10170
- US-A- 4 769 680

## Beschreibung

Die Erfindung betrifft ein Verfahren zur photomechanischen Herstellung strukturierter Oberflächen auf einem Musterträger als Abbild einer elektronisch gespeicherten Vorlage, insbesondere zum Belichten von Offsetdruckplatten, indem die Vorlage auf elektronischen Wegen in Teilbilder zerlegt wird, und die Teilbilder nacheinander auf einem Flüssigkristallbildschirm so dargestellt und auf dem Musterträger abgebildet werden, daß sich die Abbilder zu einem Gesamtabbild der Vorlage auf dem Musterträger wieder vereinigen.

Außerdem betrifft die Erfindung eine Vorrichtung zum Belichten von lichtempfindlichen Druckplatten, mit einer Lichtquelle, einer digital gespeicherten Vorlage und einem Musterträger, wobei die Vorlage in Form von Teilbildern auf einem Flüssigkristallbildschirm darstellbar ist, mittels einer im Strahlengang vorgesehenen optischen Baugruppe auf dem Musterträger abbildbar ist, wobei das Abbild und der Musterträger relativ zueinander in mindestens einer Achse bewegbar ausgebildet sind.

Offsetdruckplatten werden heute noch zu über 90% über Filmvorlagen mit Hilfe der Kontaktkopiertechnik oder vereinzelt auch mit Projektionsanlagen belichtet. Das heißt, bevor eine Offsetdruckplatte belichtet werden kann, wird eine Filmvorlage erstellt. Das geschieht mit speziell dafür entwickelten Filmbelichtern und Filmentwicklungsmaschinen.

Der Verfahrensschritt zur Erstellung der Filmvorlage verlängert nachteilig den Zeit- und Kostenaufwand bei der Bebilderung von Offsetdruckplatten.

Zur Lösung dieses Problems ist durch die DE-A-37 08 147 ein gattungsgemäßes Verfahren bekannt. Der dort beschriebene Fotoplotter hält einen Bogen aus lichtempfindlichem Material zum Zwecke einer Belichtung durch eine zugeordnete Lichtquelle. Eine zwischen der Lichtquelle und dem Bogen eingefügte Lichtventilvorrichtung hat eine parallel zum Bogen liegende Hauptfläche, die in eine Vielzahl von Unterbereichen oder Abbildungen unterteilt ist, deren Lichttransmissivitäten durch einen zugeordneten Computer einzeln gesteuert werden, damit die Belichtung diejenige einer gewünschten graphischen Darstellung oder Arbeit ist.

Des weiteren wird in der DE-A-38 13 398 ein Verfahren und eine Einrichtung vorgeschlagen, wonach bzw. womit der Prozeß zur Herstellung einer Lichtmaske zur Belichtung von Offset-Druckplatten vereinfacht und verkürzt wird. Zur Erzeugung eines latenten Bildes wird einer lichtempfindlichen Offset-Druckplatten mittels eines von einer Lichtquelle ausgesandten und mittels einer Lichtmaske modulierten Strahlenbündels die Lichtmaske als Lichtventilmatrix ausgebildet und mit Signalen angesteuert, die mit dem Bild korrelieren. Damit wird an einer Flüssigkristallschicht ein Display des gewünschten Bildes in Form von Lichtpunkten erzeugt und das Display auf die lichtempfindliche Beschichtung einer Offset-Druckplatte abgebildet.

Aus der US-PS 4,769,680 ist eine Vorrichtung zum Projizieren einer Vielzahl von gleichen Bildern eines festen Bildträgers mittels eines Paares von zwei Objektiven zur fotolithographischen Herstellung großflächiger Wafer bekannt. Es wird dabei immer dasselbe Bild eines elektronischen Schaltkreises auf den Wafer projiziert und keine Teilbilder. Ein Wechsel des Bildes erfolgt nur zwischen den Bearbeitungsschritten. Die Bilder haben einen in sich geschlossenen Bildinhalt und müssen nicht übergangslos zu einem Gesamtbild zusammengefügt werden. Insofern zeigt diese Schrift keine Verbindung zur Drucktechnik.

In der WO 91/10170 wird ebenfalls die direkte Belichtung von Wafern beschrieben, wobei jedoch als Bildvorlage eine LCD-Maske zum Einsatz kommt. Auch diese Schrift zeigt keine Verbindung zur Drucktechnik. Es wird lediglich die bekannte Maske, die sonst aus einer Vielzahl von identischen Mustern besteht, durch die Belichtung mittels eines Step-und-Repeat-Prozesses ersetzt. Auf diese Weise soll die Lagerhaltung einer Vielzahl von unterschiedlichen Masken bei der Waferherstellung vermieden werden.

In der Europäischen Patentschrift EP-A3 0 253 129 wird zur Filmbelichtung die Projektion eines Bildschirms auf den Film vorgeschlagen. Insofern betrifft diese Schrift die Rationalisierung der Filmherstellung und nicht deren Vermeidung.

Schließlich ist aus der DE-A-28 12 206 ein optischer Drucker mit einer Lichtquelle und einer zwischen dieser und dem lichtempfindlichen Aufzeichnungsträger angeordneten Schablone zur Bildung der abzudruckenden Zeichen bekannt, bei dem die Schablone als Lichtschaltmaske in integrierter Dünnfilmtechnik ausgebildet ist, deren Lichtschaltelemente durch einen Zeichengenerator elektrisch steuerbar sind und dadurch für das von der Lichtquelle ständig ausgestrahlte Licht an vorbestimmten Zeichenrasterpunkten bedarfsweise transparent sind.

Die bekannten Verfahren haben sich bisher nicht durchsetzen können, da sie sich in der Praxis als zu langsam und qualitativ mangelhaft erwiesen. Insbesondere bei der Erstellung von Offsetdruckplatten für den Zeitungsdruck sind die bekannten Verfahren ungeeignet, da die sequentielle Belichtung zu untragbaren zeitlichen Engpässen und qualitativ minderwertigen Druckplatten führt.

Aufgabe der Erfindung ist es ein Verfahren und eine Vorrichtung der eingangs genannten Art anzugeben, die bei verringerten Belichtungszeiten qualitativ bessere Offsetdruckplatten liefern.

Diese Aufgabe wird bei einem gattungsgemäßen Verfahren dadurch gelöst, daß der Informationsinhalt eines Teilbildes geprüft wird und in Abhängigkeit dieser Prüfung eine Abbildung des Teilbildes auf dem Musterträger erfolgt. Zu diesem Zweck weist die Vorrichtung eine entsprechende Bildinformationsauswerteschaltung oder -software auf.

Es kommt vor, daß nicht alle Teilbilder auch tatsächlich Bildinformationen enthalten. Erfindungsgemäß werden deshalb nur Teilbilder auf den Musterträger übertragen, die Bildinhalte aufweisen. Aufgrund der verringerten Anzahl Teilbilder verkürzt sich dadurch die gesamte Belichtungszeit in etwa proportional zu der Summe von Teilbildern ohne Bildinhalt. Dabei fährt der Belichtungskopf auf einem meanderförmigen Weg jede Position eines Teilbildes an. Die für die Restmenge noch erforderliche gesamte Belichtungszeit kann weiter herabgesetzt werden, wenn jedem Teilbild ein erster Datensatz für seinen Bildinhalt und ein zweiter Datensatz für seine Position zugeordnet wird, und der Bildinhalt eines jeden Teilbildes geprüft wird, ob Bildinformationen darin enthalten sind, und nur zusammengehörige Datensätze mit Bildinhalt zur Erzeugung einer Abfolge von Steuerdatensätzen zur Übergabe an eine numerische Steuerung verwendet werden. Dadurch können auch die zwischen den einzelnen Belichtungszeiten erforderlichen Zeiten für den Positionswechsel zwischen zwei Belichtungsorten verringert werden.

Die Zeit für die Offsetdruckplattenerstellung kann durch eine weitere Wegreduzierung verkürzt werden, indem die Menge der zweiten Datensätze so sortiert wird, daß sich eine möglichst geringe Summe von Einzelabständen zwischen den Positionen der Teilbilder ergibt und die Datensätze in dieser Reihenfolge an die numerische Steuerung übergeben werden. Auf diese Weise wird das Gesamtbild mit dem kürzesten Verfahrweg erstellt.

Hohe Verfahrgeschwindigkeiten des Belichtungskopfes erreicht man, wenn als Antrieb zur Erzeugung einer Relativbewegung zwischen Musterträger und Flüssigkristallbildschirm mindestens ein elektrischer Linearantrieb verwendet wird. Die Belichtungszeiten können sich an die auf diese Weise verkürzten Positionierzeiten ohne Wartezeit anschließen, weil Elastizitäts-, Spiel-, Reibungseffekte und Eigenschwingungen durch den elektrischen Linearantrieb weitgehend vermieden sind.

Da Offset-Druckplatten eine Welligkeit aufweisen können, die teilweise größer als 2 mm ist, und diese Unebenheiten auch unterschiedlich verteilt sind, muß durch entsprechend klein gewählte Blenden eine ausreichende Tiefenschärfe der Abbildung erreicht werden. Durch die geringe Lichtausbeute jedoch verlängern sich die Belichtungszeiten des Teilbildes. Zur Verkürzung dieser Belichtungszeiten ist vorgesehen, daß vor jeder Abbildung eines Teilbildes eine Messung des Abstandes zum Musterträger erfolgt und Abweichungen von einem voreingegebenen Wert automatisch korrigiert werden. Auf diese Weise kann man mit einer überraschend geringen Tiefenschärfe auch bei welligen Platten eine hohe Abbildungsqualität bei kurzen Belichtungszeiten erzielen. Die Korrektur kann vorzugsweise durch ein Verfahren des gesamten Belichtungskopfes erfolgen. Auf diese Weise lassen sich auch unterschiedlich dicke Offsetdruckplatten belichten. Es kann jedoch auch die Brennweite entsprechend korrigiert werden, was jedoch zu Abbildungsfehlern führen kann.

Eine gleichmäßige Abbildungsqualität über der gesamten Fläche der Vorlage erzielt man, wenn zur Abbildung eine Lichtquelle verwendet wird, deren Lichtstrom gemessen wird und Abweichungen von einem vorgegebenen Lichtstrom automatisch korrigiert werden.

Diese Korrektur kann entweder dadurch erfolgen, wenn die Korrektur durch Verändern der Belichtungszeit erfolgt oder die Korrektur durch Verändern einer elektrischen Versorgung der Lichtquelle erfolgt.

Auch die qualitativ anspruchsvollsten Druckvorlagen lassen sich mit dem Verfahren herstellen,wenn der Flüssigkristallbildschirm im Maßstab verändert, vorzugsweise verkleinert, abgebildet wird. Es lassen sich durch entsprechende Verkleinerung des Flüssigkristallbildschirms Auflösungen von beispielsweise 2540 DPI erzielen. Allerdings ist dadurch auch die Vorlage in entsprechend viele Teilbilder aufzugliedern, die nacheinander belichtet und zu der Gesamtvorlage zusammengefügt werden. Durch die so erhöhte Anzahl Einzelbelichtungen steigt die gesamte Belichtungszeit der Vorlag erheblich.

Wenn eine Positionierung der Teilbilder mit einer Genauigkeit von besser als 5 µm, insbesondere besser als 2 µm erfolgt, schließen sich die einzelnen Teilbilder lückenlos aneinander.

Die gesamte Belichtungszeit einer Vorlage kann dadurch verringert werden, daß gleichzeitig mehrere Teilbilder abgebildet werden.

Kollisionen von verschiedenen Belichtungsköpfen vermeidet man dadurch, daß eine Relativbewegung mehrerer Abbilder zum Musterträger sychron erfolgt. Der Abstand der hintereinander gereihten, gleichzeitig abgebildeten Teilbilder bleibt dabei vorteilhaft konstant. Da die Wahrscheinlichkeit sinkt, daß beide Belichtungsköpfe gleichzeitig keine Bildinhalte aufweisen, und eine Belichtungsposition gleichzeitig übersprungen werden kann, ist vorteilhaft, wenn in einem vorgegebenen Grenzbereich, sich die Belichtungsköpfe unabhängig voneinander bewegen können.

Dadurch, daß ein Abstand zwischen zwei gleichzeitig belichteten Abbildern veränderbar ist, können Vorlagen mit unterschiedlichen Auflösungen mit derselben Belichtungsvorrichtung belichtet werden. Der Abstand zweier gleichzeitiger Abbildungen beträgt ein ganzzahliges Vielfaches der Einzelbildabmessungen.

Ein besonders gleichmäßiges Belichtungsergebnis erhält man, wenn die Lichtquelle konstant betrieben wird und dabei der Lichtstrom mittels eines Verschlusses geschaltet wird, der vorzugsweise um eine zum Strahlengang senkrechte Drehachse rotiert.

Besonders gute Ergebnisse lassen sich erzielen, wenn das Teilbild mittels eines Raster-Imageproßessers nach einem Frequenzrasterverfahren aufbereitet wird.

Eine größere Gleichmäßigkeit der Übergänge erreicht man dadurch, daß die Teilbilder sich überlappend abgebildet werden. Im Bereich der Überlappungen vom Bilderrand zum Inneren hin wird der Schwärzungsgrad linear ansteigend angepaßt, so daß sich durch die Überlagerung eine dem Originalbild entsprechende Verteilung ergibt.

Die Vorrichtungsaufgabe wird bei einer gattungsgemäßen Vorrichtung dadurch gelöst, daß eine Meß- und Regelvorrichtung für die Messung und Regelung des Abstandes des Flüssigkristallbildschirms oder eines Belichtungskopfes zum Musterträger für jedes Teilbild vorgesehen ist. Vor jeder Belichtung wird mittels der Meßvorrichtung der Abstand zum Musterträger ermittelt. Als Meßvorrichtung sind beispielsweise bekannte Lasermeßvorrichtungen geeignet. Dabei wird der Abstand durch interferometrische Längenmessung bestimmt. Die Abstandsmessung kann jedoch auch durch bekannte akustische oder optische Meßverfahren ermittelt werden. Durch Vergleiche mit einem vorgegebenen Sollwert wird eine Stellgröße bestimmt, die dann über ein entsperechendes Stellglied den Abstand nachregelt. Dies kann beispielsweise auch durch Verstellen der Brennweite oder durch motorische Höhenverstellung des Belichtungskopfes oder von Teilen desselben erfolgen. Aufgrund der erfindungsgemäß vorgesehenen Regelung kann mit Lichtquellen gearbeitet werden, die einen großen Raumwinkel überstreichen, so daß aufgrund der hohen Lichtausbeute kurze Belichtungszeiten möglich sind.

Die gesamte Vorlage wird mit gleichbleibender Qualität über die gesamte Fläche abgebildet, wenn ein Sensor zur Messung des Lichtstromes und ein Regelkreis zur Korrektur von Abweichungen des Lichtstromes von einem Soll-Wert vorgesehen ist. Dadurch können auch langsame Änderungen der Lichtausbeute keinen Einfluß auf das Arbeitsergebnis ausüben.

Beispielsweise können Veränderungen, die über einen längeren Zeitraum sich bemerkbar machen, dadurch korrigiert werden, daß im Regelkreis eine Stellvorrichtung zur Veränderung einer Belichtungszeit vorgesehen ist. Dabei ist der Sensor zur Messung des Lichtstromes vorzugsweise in der Nähe des Musterträgers angeordnet, so daß der auf den Musterträger auftreffende Lichtstrom vor Beginn der Belichtung der Teilbilder einmal erfaßt wird.

Kurzfristige Änderungen, die beispielsweise durch Schwankungen der Netzversorgungsspannungen entstehen, können ausgeglichen werden, wenn im Regelkreis eine Stellvorrichtung zur Veränderung des Lichtstromes vorgesehen ist. Hierbei wird der Lichtsensor vorzugsweise in der Nähe der Lichtquelle angeordnet oder direkt die Versorgungsspannung gemessen. Durch bekannte Schaltungen läßt sich somit beispielsweise die Versorgungsspannung konstant halten.

Ein häufiges Schalten kann vermieden werden, wenn ein Verschluß zum Schalten des Lichtstromes vorgesehen ist. Dadurch erhöht sich die Lebensdauer der Lampe.

Die Verschlußzeiten lassen sich vorteilhaft schnell ändern, dadurch daß der Verschluß als rotierender Körper ausgebildet ist, mit einer Rotationsachse, die im wesentlichen senkrecht zum Strahlengang angeordnet ist. Dabei ist vorgesehen, daß der rotierende Körper teilweise als Zylinder mit Ausschnitten ausgebildet ist. Ein solcher Körper weist nämlich eine vorteilhaft geringeres Trägheitsmoment auf und ermöglicht außerdem eine kompakte Bauweise. Als Antrieb wird dabei vorzugsweise ein bürstenloser Gleichstrommotor verwendet, der besonders gute Regeleigenschaften besitzt.

Eine weitere Verkürzung der Belichtungszeit läßt sich erreichen, wenn der Belichtungskopf optische Elemente aufweist, die aus Quarzglas bestehen. Derartiges Glas weist im ultravioletten Spektralbereich des Lichtes vorteilhaft hohe Lichtdurchlässigkeit auf, so daß sich die UV-lichtempfindlichen Offsetdruckplatten in kürzerer Zeit belichten lassen.

Besonders hohe Verfahrgeschwindigkeiten und Beschleunigungen lassen sich erzielen, wenn nicht Musterträger mitsamt einer notwendigen Aufspannplatte, sondern stattdessen Lichtquelle, Bildschirm und optische Baugruppe zu einem Belichtungskopf zusammengefaßt sind, der verfahrbar ausgebildet ist. Es können so mehr als 10 Teilbilder in der Sekunde positioniert und belichtet werden.

Ein besonders vorteilhaftes dynamisches Verhalten der Gesamtvorrichtung ergibt sich, wenn mindestens ein Antrieb zur Erzeugung einer Reltivbewegung zwischen Belichtungskopf und Musterträger als Linearantrieb ausgebildet ist. Solche Antriebe weisen eine hohe Positioniergenauigkeit auf, die besser als 2 µm ist.

Wenn dem Bildschirm ein Polarisationsfilter zugeordnet ist, der getrennt vom Bildschirm ausgebildet ist lassen sich auch besonders starke Lichtquellen verwenden, da die sich in den einzelnen Bauteilen entwickelnde Wärme über die dadurch erzeugte große Oberfläche leichter abführen läßt.

Die Gesamtvorlage läßt sich in noch kürzerer Zeit fertigstellen, indem mehrere Belichtungsköpfe auf einer Achse angeordnet sind.

Eine besonders günstige Konstruktion ergibt sich, wenn jedem Belichtungskopf ein eigener Linearantrieb zugeordnet ist und für die andere Achse ein gemeinsamer Linearantrieb für alle Belichtungsköpfe vorgesehen ist. Dabei nimmt man in Kauf, daß in einer Achse die Feststellgeschwindigkeit etwas geringer ist, als die der beiden Köpfe in die andere Richtung. Dies beeinflußt die Gesamtbelichtungszeit nur geringfügig. Dadurch, daß jeder Belichtungskopf in der anderen Richtung seinen eigenen Linearantrieb aufweist, kann auch kurzfristig auf unterschiedliche Auflösungen umgeschaltet werden, indem die Belichtungsköpfe so verfahren werden, daß sich ein größerer oder kleinerer Zwischenraum ergibt. Außerdem wird entsprechend der Abbildungsmaßstab der Flüssigkristallbildschirm geändert. Dies kann durch Veränderung der Brennweite geschehen.

Eine Konstruktion, bei der die optische Baugruppe (8) als Spiegelsystem ausgebildet ist, weist den Vorteil auf, daß bei den hohen Frequenzen von Einzelbelichtungen aufgrund der niedrigen Bauhöhe weniger Schwingungen in die gesamte Vorrichtung eingeleitet werden und dadurch das dynamische Verhalten der Vorrichtung verbessert wird.

Als besonders geeignet hat sich ein Flüssigkristallbildschirm herausgestellt, der als aktiver Flüssigkristallbildschirm ausgebildet ist. Dadurch werden vorteilhaft hohe Kontrastwerte erzielt, die auch bei Projektion eine überraschend gute Abbildungsqualität ermöglichen.

Wenn der Strahlengang, vorzugsweise mittels eines Spiegels 10, lenkbar ausgebildet ist, können auch gekrümmte Offsetdruckplatten belichtet werden.

Dazu ist vorgesehen, daß der Musterträger 11 gekrümmt ausgebildet ist.

Insbesondere bei Verwendung eines Flüssigkristall-Projektionsdisplays, das als aktives Display ausgebildet ist, reicht es aus, wenn der Flüssigkeitsbildschirm als Belichtungsverschluß wirkend ausgebildet ist.

Die Musterträger lassen sich bequem aufspannen und ihre Ebenheit verbessert sich, wenn sie einen Aufspanntisch für Musterträger aufweist, der als Saugtisch ausgebildet ist.

Die Erfindung wird in einer bevorzugten Ausführungsform unter Bezugnahme auf eine Zeichnung beschrieben, wobei weitere vorteilhafte Einzelheiten der Zeichnung zu entnehmen sind. Funktionsmäßig gleiche Teile sind dabei mit denselben Bezugszeichen versehen.

Die Figuren zeigen im einzelnen:
- Figur 1: einen schematischen Vertikalschnitt durch die erfindungsgemäße Vorrichtung mit zwei alternativen Ausführungsformen;
- Fig. 2: eine schematische perspektivische Darstellung des Belichtungsgerätes;
- Fig. 3: ein Blockschema mit Funktionsgruppen der elektronischen Steuerung;
- Fig. 4: eine Aufsicht auf ein Belichtungsgerät;
- Fig. 5: eine Seitenansicht des Belichtungsgerätes gem. Pfeil V in Fig. 4
- Fig. 6: eine weitere Seitenansicht des Belichtungsgerätes gem. Pfeil VI in Fig. 5;
- Fig. 7: ein Vertikalschnitt durch einen Belichtungskopf gem. Pfeilen VII-VII in Fig.6;
- Fig. 8: eine Seitenansicht des Verschlusses und
- Fig. 9: einen Horizontalschnitt durch den Verschluß.

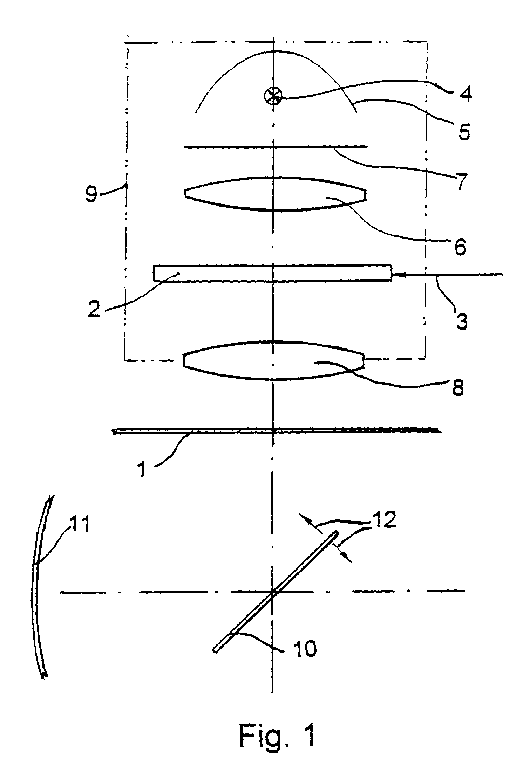

In Figur 1 bezeichnet 1 eine zu belichtende Offsetdruckplatte. Eine auf dieser Druckplatte abzubildende Vorlage ist digital in einem nicht zeichnerisch dargestellten Computer gespeichert. Mittels geeigneter Programme wird die Vorlage in Teilbilder zerlegt und in bekannter Weise über eine Steuerleitung 3 auf einem 2 sichtbar gemacht.

Zur Belichtung der Druckplatte 1 ist oberhalb des Flüssigkristallbildschirms eine Lichtquelle 4 mit Reflektor 5 angeordnet, deren Strahlung von einem Kollimator 6 optisch ins Unendliche gesetzt wird und auf diese Weise den Flüssigkristallbildschirm bestrahlt. Zwischen Kollimator 6, von dem schematisch nur eine Linse angedeutet ist, und der Lichtquelle 4 ist im Strahlengang noch ein Filter 7 angeordnet, das im wesentlichen die langwellige infrarote Strahlung ausfiltern soll, damit überwiegend der ultraviolette Lichtanteil, der von der Lichtquelle emittiert wird, zur Belichtung genutzt werden kann. Als Lichtquelle ist vorzugsweise ein Metall-Halogenid-Strahler verwendbar.

Eine zweite optische Baugruppe 8 dient zur verkleinerten Abbildung des auf dem Flüssigkristallbildschirm 2 sichtbaren Musters.

Zur Belichtung wird die Lichtquelle für die benötigte Lichtmenge kurzfristig mit ausreichendem Strom versorgt. Diese Betriebsweise, unter Verwendung entsprechender Blitzlampen, weist den Vorteil einer gegenüber Dauerbetrieb verringerten Verlustleistung.

Alternativ kann jedoch auch ein bekannter Verschluß vorgesehen werden, der mit einer entsprechenden Steuereinheit die Belichtungszeit bestimmt.

Die Lichtquelle 4 mit Reflektor 5, Filter 7, Kollimator 6, Flüssigkristallbildschirm 2 und optischer Baugruppe 8 sowie etwaig zusätzlich günstiger optischer Bauteile, ggf. Lichtverschlußsystem und Kühlsystemen werden vorteilhaft in einem Belichtungskopf 9 zusammengefaßt.

Nach der Belichtung eines Teilbildes wird Belichtungskopf 9 gegenüber Druckplatte 1 um das dem Teilbildausschnitt entsprechende Rastermaß relativ zueinder verschoben. Die Belichtung des nächsten Teilbildes erfolgt in der Weise, daß sich die Teilbilder lückenlos aneinander anschließen und sich in ihren Bildinhalten zum Gesamtbild ergänzen.

Die Führung der Belichtungsorte über die Oberfläche der Druckplatte kann alternativ auch mittels eines schwenkbaren Spiegels 10 erfolgen. Zur Vermeidung von Abbildungsfehlern ist dabei statt der in Figur 1 dargestellten planen Druckplatte 1 eine gekrümmt aufgespannte Druckplatte 11 vorgesehen. Der im Strahlengang angeordnete Spiegel 10 wirft das Licht auf diese Druckplatte 11. Für die darauffolgende Belichtung wird er um ein entsprechendes Winkelinkrement in Richtung der Pfeile 12 verschwenkt. Anschließend erfogt der nächste Belichtungsvorgang.

Auf diese Weise besteht die Möglichkeit mit Hilfe moderner Datenverarbeitungsanlagen erstellte Vorlagen direkt auf einem Druckträger abzubilden. Die Kosten zur Erstellung eines Filmes und der damit verbundene Zeitaufwand entfallen.

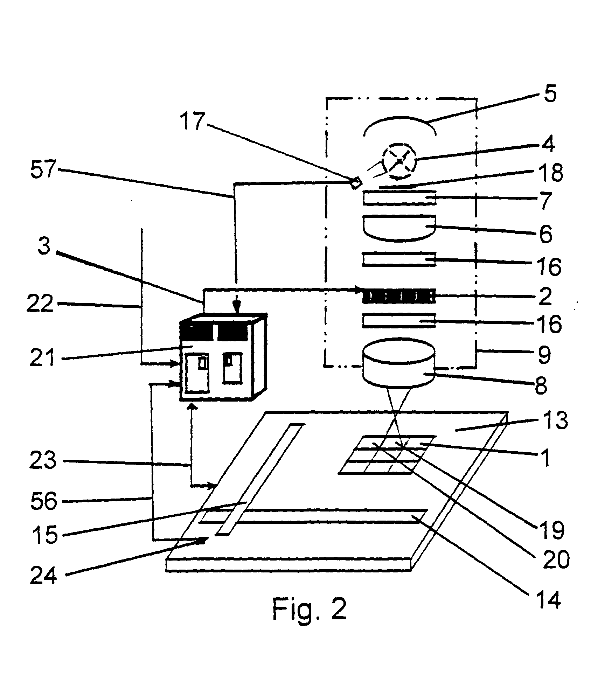

In Fig. 2 ist nochmals schematisch und teilweise perspektivisch das erfindungsgemäße Belichtungsgerät dargestellt. Der Musterträger 1 ist auf einer Aufspannplatte 13 fixiert. In dieser Aufspannplatte 13 sind zwei orthogonal zueinander angeordnete Führungen für die X-Achse 14 und für die Y-Achse 15 fest verbunden. Der bewegliche Belichtungskopf 9 ist mittels nicht dargestellter elektischer Linearantriebe entlang der Führungen 14, 15 bewegbar.

Zusätzlich zu dem in Fig. 1 dargestellten Belichtungskopf sind getrennt vom Flüssigkristallbildschirm 2 Polarisationsfilter 16 vorgesehen, die aus einem Material gefertigt sind, das im ultravioletten Spektralbereich möglichst wenig Licht absorbiert. Zusätzlich wird die thermische Belastung des Flüssigkeitskristallbildschirms 2 verringert. Als Lichtquelle 4 ist eine Metallalogenitlampe vorgesehen, die eine gewisse Zeit betrieben werden muß, bis sie ihre volle Leistung erreicht. Der von der Lichtquelle 4 ausgehende Lichtstrom wird mittels eines Lichtsensors 17 gemessen und über Signalleitung 57 der Ansteuerungselektronik übermittelt. Entsprechend der gemessenen Stärke des Lichtstromes wird die Belichtungszeit vorgegeben und ein zwischen Lichtquelle 4 und Filter 7 vorgesehener Verschluß 18 für die Dauer der Belichtungszeit geöffnet. Auf diese Weise wird ein erstes Teilbild 19 auf dem Musterträger belichtet. Anschließend wird der Belichtungskopf 9 um eine Bildteilung, beispielsweise in Richtung der X-Achse 14 verschoben und ein weiteres Teilbild 20 als Abbild des auf dem Flüssigkristallschirm 2 dargestellten Musters belichtet.

Zur Erzeugung der hierfür erforderlichen Muster auf dem Flüssigkristallbildschirm ist eine Ansteuerungselektronik 21 vorgesehen, die über Steuerleitung 3 vor jedem Belichten eines Teilbildes das entsprechende Muster auf dem Flüssigkristallbildschirm darstellt. Die Dateneingabe in die Ansteuerungselektronik 21 erfolgt beispielsweise über Datenleitung 22, die der Ansteuerungselektronik die erforderlichen Bildinhalte und deren Position mitteilt. Die Ansteuerungselektronik 21 steuert über Signalleitung 23 nicht einzeln dargestellte Antriebe zum Verfahren des Belichtungskopfes 9 an.

Alternativ oder ergänzend zum Lichtsensor 17 kann auch ein Lichtsensor 24 auf der Aufspannplatte vorgesehen sein, der vor dem Belichten des Musterträgers einmal angefahren wird und den von der Lichtquelle 4 ausgehenden Lichtstrom mißt. Das Signal des Lichtsensors 24 wird über Signalleitung 56 einem Regelkreis zugeführt, der die Belichtungszeit oder die Netzversorgung der Lichtquelle regelt. Der Lichtsensor 24 hat den Vorteil, daß er den wirklich am Musterträger ankommenden Lichtstrom mißt, so daß auch über lange Zeiträume sich verändernde optische Qualität der Bauelemente mit erfaßt und korrigiert werden kann.

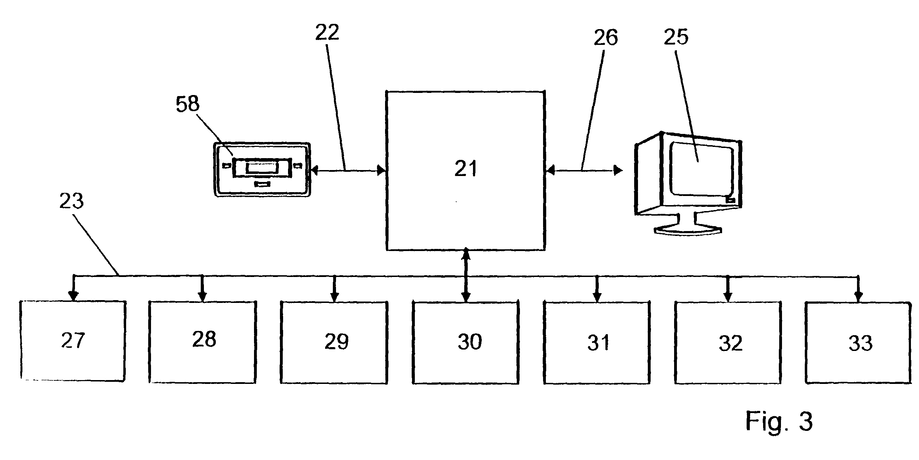

In Fig. 3 ist die elektronische Steuerung in Form von einzelnen Blöcken schematisch dargestellt.

Die für den Druck vorgesehenen Vorlagen werden elektronisch in Teilbilder mittels eines Raster-Image-Prozessors zerlegt und auf einem magneto-optischen Datenträger zwischengespeichert. Als solcher kann er durch ein an die Ansteuerungselektronik 21 des Belichtungsgerätes angeschlossenes magneto-optisches Laufwerk 58 gelesen werden und die für die Steuerung erforderlichen Daten bereitstellen. Zusätzliche Eingaben und Befehle können über ein Bedien-Terminal 25 erfolgen, das über Datenleitung 26 ebenfalls an die elektronischen Ansteuerungselektronik 21 angeschlossen ist. Die verschiedenen Funktionseinheiten 27 bis 33 sind über eine als Feld ausgestaltete Signalleitung 23 mit der Ansteuerungselektronik 21 verknüpft.

Die Ansteuerungselektronik 21 tauscht über Signalleitung 23 mit den Funktionsgruppen 27 bis 33 des Belichtungsgerätes Daten aus. Von einer Abstandsmessung 27, die beispielsweise als Laser-Entfernungsmeßgerät 51 ausgebildet ist, erhält die Ansteuerungselektronik 21 den aktuellen Abstand zum Musterträger. Bei Abweichungen von einem vorher eingestellten Sollwert, wird dann ein entsprechender Stellbefehl zur Funktionsgruppe der Abstandsregelung oder Brennweitenregelung 28 generiert, so daß dann der Abstand oder die Brennweite entsprechen korrigiert wird, um eine möglichst große Schärfe der Abbildung auf dem Musterträger zu erzielen. Entsprechend wird das Ergebnis einer Belichtungsmessung 29 mit einem voreingestellten Sollwert verglichen und ein entsprechendes Korrektursignal an die Verschlußregelung 30 oder Lichtquellenregelung 33 generiert. Die momentane Lage der Belichtungsköpfe wird von Meßköpfen der Steuerung übermittelt, die an den Achsen angeordnete Maßstäbe lesen. Die Steuerung generiert die notwendigen Verfahrenssignale für die Antriebsmotore. Diese Funktionen sind als Block für die Antriebsregelung 31 zusammengefaßt.

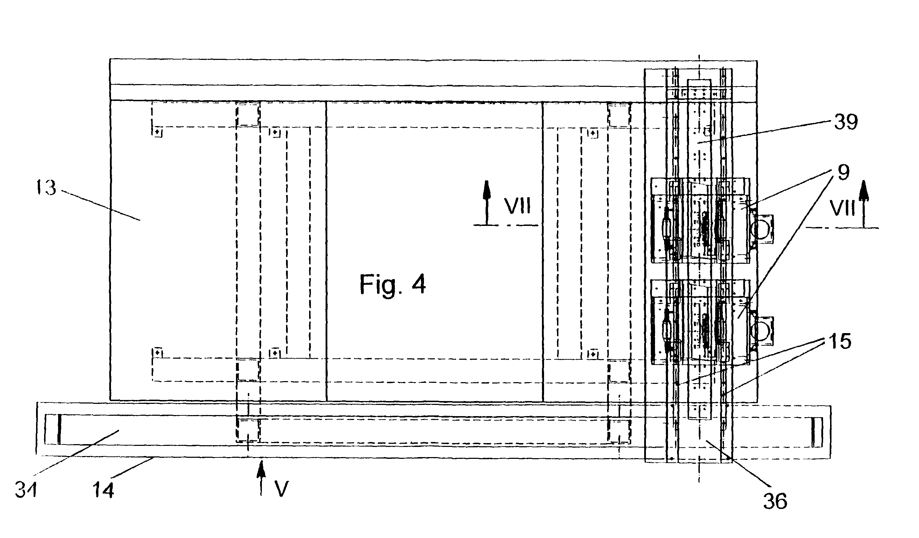

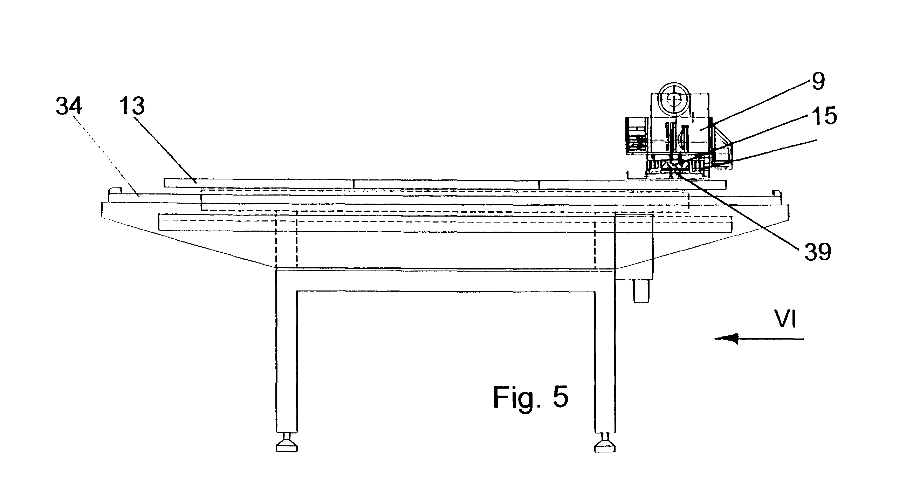

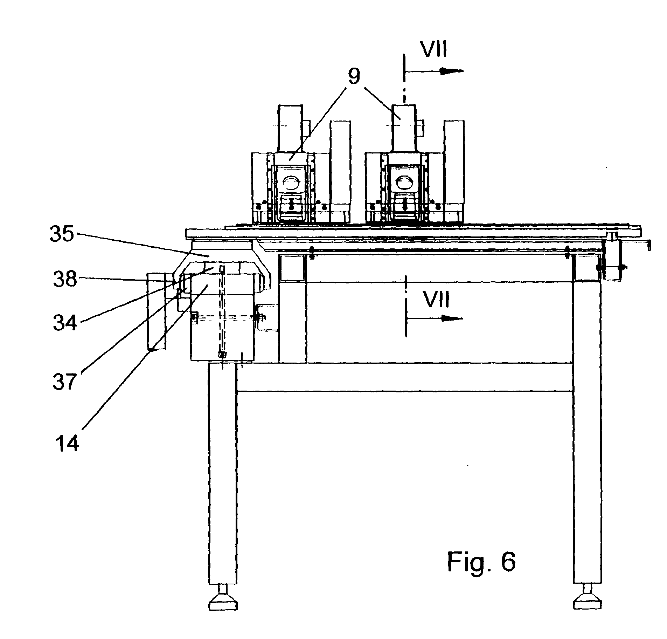

In Fig. 4, 5 und 6 ist der mechanische Aufbau des Belichtungsgerätes dargestellt. Mit der Aufspannplatte 13 ist fest eine Führung für die X-Achse 14 verbunden. Auf der Führung 14 ist das Sekundärteil 34 eines ersten elektrischen Linearantriebs befestigt. Während das Primärteil 35 an einem Schlitten 36 befestigt ist. Dadurch kann Schlitten 36 entlang der Führung 14 in richtung der X-Achse verfahren werden. Zusätzlich ist ein Maßstab 37 (Fig. 6) vorgesehen, der von einem am Schlitten 36 angebrachten Meßkopf 38(Fig. 6) gelesen wird. Diese Teile gehören zu einem an sich bekannten linearen Wegmeßsystem, das die Position des Schlittens 36 an die Ansteuerungselektronik 21 meldet.

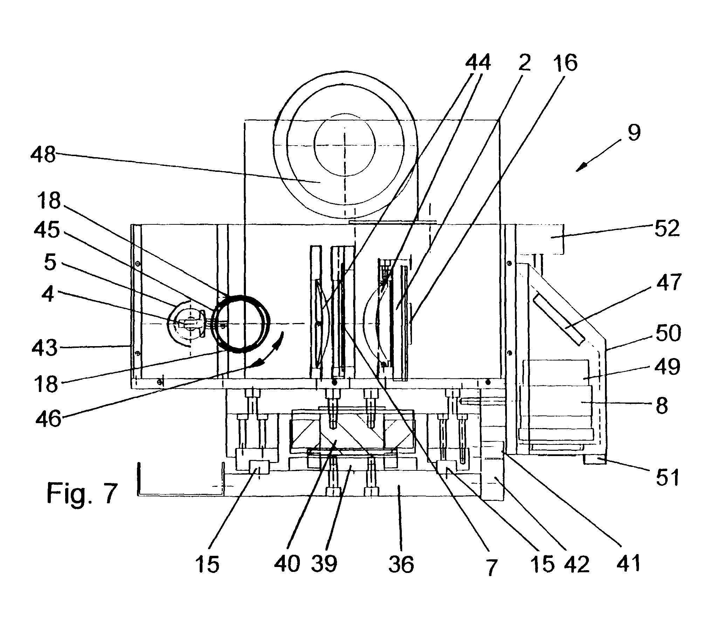

Auf dem Schlitten 36, der sich über die gesamte Breite der Aufspannplatte 13 erstreckt, sind zwei Führungsschienen 15 vorgesehen, entlang denen zwei Belichtungsköpfe 9 verfahrbar sind. Zu diesem Zweck ist auf Schlitten 36 ein Sekundärteil 39 eines zweiten elektrischen Linearantriebs befestigt. Zu jedem Belichtungskopf 9 gehört ein eigenes Primärteil 40 des zweiten elektrischen Linearantriebs. Die elektrischen Linearantriebe sind als Synchronantriebe ausgebildet. Auch zu den zweiten Linearantrieben gehören lineare Wegmeßsysteme, die die Postion der Belichtungsköpfe an die Ansteuerungselektronik 21 zurückmelden. Hierzu ist auf dem Schlitten 36 ein entsprechender Maßstab 42 (Fig. 7) in Richtung der Führung 15 vorgesehen, der von an den Belichtungsköpfen 9 befestigten Meßköpfen 41 (Fig. 7) abgetastet wird.

Fig. 7 zeigt einen Vertikalschnitt durch einen der Belichtungsköpfe 9. In einem Gehäuse 43 sind ein Linsensystem 44 zur Abbildung des auf dem Flüssigkristallbildschirm 2 erzeugten Musters vorgesehen. Zu diesem Zweck wird der Lichtstrom der Lichtquelle 4 zunächst horizontal durch den Reflektor 5 auf den Verschluß 18 gerichtet. Verschluß 18 ist in Richtung des Pfeiles 46 drehbar, so daß die in Verschluß 18 vorgesehenen Öffnungen 45 den Lichtstrom schalten können. Das Licht wird dann von dem Linsensystem 44 auf den Flüssigkristallbildschirm 2 gerichtet und durch Filter 7 gefiltert. Nach Durchtritt durch den Flüssigkristallbildschirm 2 fallen die Strahlen auf den Spiegel 47, der den Strahlengang um 90° auf die optische Baugruppe 8 richtet, die schließlich das Bild auf dem Musterträger abbildet.

Zur Beseitigung der im Gehäuse 43 entstehenden Wärme ist ein Gebläse 48 oben auf dem Gehäuse 43 angeordnet. Durch die vertikale Anordnung der Teile im Gehäuse 43, kann auf diese Weise die Wärme gut abgeführt werden. Spiegel 47 und Objektiv 49 sind in einem eigenen Gehäuse 50 eingebaut, das vertikal verschiebbar am Gehäuse 43 befestigt ist. Ein am Gehäuse 50 angeordneter Entfernungsmeßkopf 51 mißt die Entfernung zum Musterträger. Bei Abweichungen vom Sollwert, kann die Lage des Gehäuses 15 mittels eines am Gehäuse 43 befestigten Stellantriebs 52, verändert werden. Der Stellantrieb ist als Spindel-Muttersystem ausgebildet ist, wobei die Mutter vorzugsweise am Gehäuse 50 befestigt ist und Motor mit Spindel fest mit Gehäuse 43 verbunden ist.

Alternativ kann auch durch einen entsprechenden Stellantrieb die Brennweite des Objektivs 49 verändert werden.

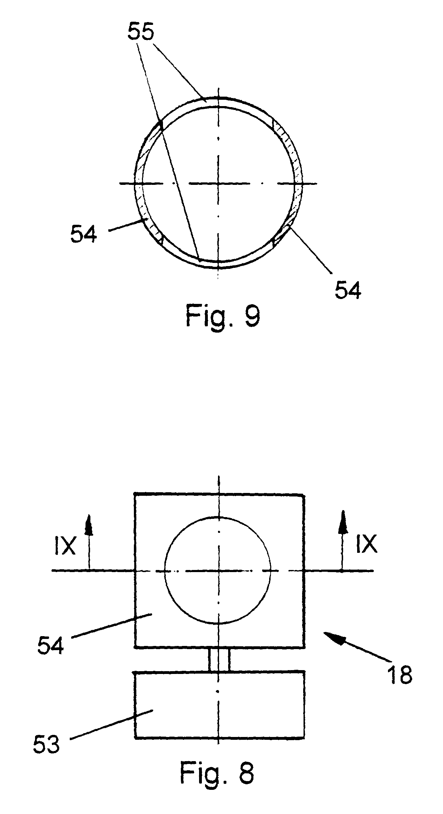

In Fig. 8 ist schematisch der Verschluß 18 dargestellt. Er besteht aus Motor 53. Dieser ist vorzugsweise als bürstenloser Gleichstrommotor ausgebildet. Auf seiner Drehachse ist ein zylindrischer Rohrabschnitt 54 vorgesehen, in den die Drehachse durchsetzende Öffnungen 55 eingebracht sind. Der Hohlzylinder hat ein vorteilhaft niedriges Trägheitsmoment und ermöglicht eine besonders kompakte Bauweise des Belichtungskopfes.

Zusätzlich kann auch eine verstellbare Blende im Strahlengang angeordnet werden, beispielsweise in Form einer Irisblende, um eine leichtere Anpassung an unterschiedlich lichtempfindliche Trägermaterialien vornehmen zu können.

### Bezugszeichenliste

- 1: Druckplatte
- 2: Flüssigkristallbildschirm
- 3: Steuerleitung
- 4: Lichtquelle
- 5: Reflektor
- 6: Kollimator
- 7: Filter
- 8: optische Baugruppe
- 9: Belichtungskopf
- 10: Spiegel
- 11: Druckplatte
- 12: Pfeil
- 13: Aufspannplatte
- 14: Führung (X-Achse)
- 15: Führung (Y-Achse)
- 16: Polarisationsfilter
- 17: Lichtsensor
- 18: Verschluß
- 19: Teilbild
- 20: Teilbild
- 21: Aussteuerungselektronik
- 22: Datenleitung
- 23: Signalleitung
- 24: Lichtsensor
- 25: Bedienterminal
- 26: Datenleitung
- 27: Abstandsmessung
- 28: Abstands- oder Brennweitenregelung
- 29: Belichtungsmessung
- 30: Verschlußregelung
- 31: Antriebsregelung für Linearmotore
- 32: Blendensteuerung
- 33: Lichtquellenregelung
- 34: Sekundärteil
- 35: Primärteil (erster Antrieb)
- 36: Schlitten
- 37: Maßstab
- 38: Meßkopf
- 39: Sekundärteil
- 40: Primärteil
- 41: Meßkopf
- 42: Maßstab
- 43: Gehäuse
- 44: Linsensystem
- 45: Öffnungen
- 46: Pfeil
- 47: Spiegel
- 48: Gebläse
- 49: Objektiv
- 50: Gehäuse
- 51: Entfernungsmeßkopf
- 52: Stellantrieb
- 53: Motor
- 54: Rohrabschnitt
- 55: Öffnungen
- 56: Signalleitung
- 57: dto.
- 58: Magneto-Optisches-Datenlaufwerk

## Patentansprüche

1. Verfahren zur photomechanischen Herstellung strukturierter Oberflächen auf einem Musterträger (1) als Abbild einer elektronisch gespeicherten Vorlage, insbesondere zum Belichten von Offsetdruckplatten, indem die Vorlage auf elektronischen Wegen in Teilbilder zerlegt wird, und die Teilbilder nacheinander auf einem Flüssigkristallbildschirm (2) so dargestellt und auf dem Musterträger (1) abgebildet werden, daß sich die Abbilder zu einem Gesamtabbild der Vorlage auf dem Musterträger (1) wieder vereinigen, **dadurch g e k e n nzeichnet,** daß durch eine Auswerteschaltung oder -software der Bildinhalt eines jeden Teilbildes geprüft wird, ob Bildinformationen darin enthalten sind, und in Abhängigkeit von dieser Prüfung eine Abbildung des Teilbildes auf dem Musterträger (1) erfolgt.

2. Verfahren nach Anspruch 1, **dadurch gekennzeichnet, daß** jedem Teilbild ein erster Datensatz für seinen Bildinhalt und ein zweiter Datensatz für seine Position zugeordnet wird, und daß nur zusammengehörige Datensätze mit Bildinhalt zur Erzeugung einer Abfolge von Steuerdatensätzen zur Übergabe an eine numerische Steuerung verwendet werden.

3. Verfahren nach Anspruch 2, **dadurch gekennzeichnet, daß** die Menge der zweiten Datensätze so sortiert wird, daß sich eine möglichst geringe Summe von Einzelabständen zwischen den Positionen der Teilbilder ergibt und die Datensätze in dieser Reihenfolge an die numerische Steuerung übergeben werden.

4. Verfahren nach Anspruch 1, 2 oder 3, **dadurch gekennzeichnet, daß** als Antrieb zur Erzeugung einer Relativbewegung zwischen Musterträger (1) und Flüssigkristallbildschirm (2) mindestens ein elektrischer Linearantrieb (34, 35, 39, 40) verwendet wird.

5. Verfahren nach Anspruch 1, 2, 3 oder 4, **dadurch gekennzeichnet, daß** vor jeder Abbildung eines Teilbildes eine Messung des Abstandes des Flüssigkristallbildschirms (2) zum Musterträger (1) erfolgt und Abweichungen von einem voreingegebenen Wert automatisch korrigiert werden.

6. Verfahren nach Anspruch 1, 2, 3, 4 oder 5, **dadurch gekennzeichnet, daß** zur Abbildung eine Lichtquelle (4) verwendet wird, deren Lichtstrom gemessen wird und Abweichungen von einem vorgegebenen Lichtstrom automatisch korrigiert werden.

7. Verfahren nach Anspruch 6, **dadurch gekennzeichnet, daß** die Korrektur durch Verändern der Belichtungszeit erfolgt.

8. Verfahren nach Anspruch 6, **dadurch gekennzeichnet, daß** die Korrektur durch Verändern einer elektrischen Versorgung der Lichtquelle (4) erfolgt.

9. Verfahren nach einem der vorhergehenden Ansprüche, **dadurch gekennzeichnet, daß** der Flüssigkristallbildschirm (2) im Maßstab verändert, vorzugsweise verkleinert, abgebildet wird.

10. Verfahren nach einem der vorhergehenden Ansprüche, **dadurch gekennzeichnet, daß** eine Positionierung der Teilbilder mit einer Genauigkeit von besser als 5 *µ*m, insbesondere besser als 2 *µ*m erfolgt.

11. Verfahren nach einem der vorhergehenden Ansprüche, **dadurch gekennzeichnet, daß** mehrere Teilbilder gleichzeitig abgebildet werden.

12. Verfahren nach Anspruch 11, **dadurch gekennzeichnet, daß** eine Relativbewegung mehrerer Abbilder zum Musterträger (1) sychron erfolgt.

13. Verfahren nach Anspruch 11 oder 12, **dadurch gekennzeichnet, daß** ein Abstand zwischen zwei gleichzeitig belichteten Abbildern veränderbar ist.

14. Verfahren nach einem der vorhergehenden Ansprüche, **dadurch gekennzeichnet, daß** der Lichtstrom mittels eines Verschlusses (18) geschaltet wird, der vorzugsweise um eine zum Strahlengang senkrechte Drehachse rotiert.

15. Verfahren nach einem der vorhergehenden Ansprüche, **dadurch gekennzeichnet, daß** das Teilbild mittels eines Raster-Image-Processors nach einem Frequenzrasterverfahren erzeugt wird.

16. Verfahren nach einem der vorhergehenden Ansprüche, **dadurch gekennzeichnet,daß** die Teilbilder sich überlappend abgebildet werden.

17. Vorrichtung zum Belichten von lichtempfindlichen Druckplatten, mit einer Lichtquelle (4), einer digital gespeicherten Vorlage und einem Musterträger (1), wobei die Vorlage in Form von Teilbildern auf einem Flüssigkristallbildschirm (2) darstellbar ist, mittels einer im Strahlengang vorgesehenen optischen Baugruppe (8) auf dem Musterträger (1) abbildbar ist, wobei das Abbild und der Musterträger (1) relativ zueinander in mindestens einer Achse bewegbar ausgebildet sind, **dadurch gekennzeichnet, daß** eine Meß- und Regelvorrichtung (28) für die Messung und Regelung des Abstandes des Flüssigkristallbildschirms (2) oder eines Belichtungskopfes (9) zum Musterträger (1) für jedes Teilbild vorgesehen ist.

18. Vorrichtung nach Anspruch 17, **dadurch gekennzeichnet, daß** ein Sensor (17, 24) zur Messung des Lichtstromes und ein Regelkreis (30, 33) zur Korrektur von Abweichungen des Lichtstromes von einem Sollwert vorgesehen ist.

19. Vorrichtung nach Anspruch 17 oder 18, **dadurch gekennzeichnet, daß** im Regelkreis (30) eine Stellvorrichtung zur Veränderung einer Belichtungszeit vorgesehen ist.

20. Vorrichtung nach Anspruch 17, 18 oder 19, **dadurch gekennzeichnet, daß** im Regelkreis (33) eine Stellvorrichtung zur Veränderung des Lichtstromes vorgesehen ist.

21. Vorrichtung nach Anspruch 17, 18, 19 oder 20, **dadurch gekennzeichnet, daß** ein Verschluß (18) zum Schalten des Lichtstromes vorgesehen ist.

22. Vorrichtung nach Anspruch 21, **dadurch gekennzeichnet, daß** der Verschluß (18) als rotierender Körper (54) ausgebildet ist, mit einer Rotationsachse, die im wesentlichen senkrecht zum Strahlengang angeordnet ist.

23. Vorrichtung nach Anspruch 22, **dadurch gekennzeichnet, daß** der rotierende Körper (54) teilweise als Zylinder mit Ausschnitten ausgebildet ist.

24. Vorrichtung nach Anspruch 22 oder 23, **dadurch gekennzeichnet, daß** als Antrieb (53) des Verschlusses ein bürstenloser Gleitstromantrieb vorgesehen ist.

25. Vorrichtung nach einem der Ansprüche 17 bis 24, **dadurch gekennzeichnet, daß** dem Bildschirm (2) ein Polarisationsfilter (16) zugeordnet ist, der getrennt vom Bildschirm (2) ausgebildet ist.

26. Vorrichtung nach einem der Ansprüche 17 bis 25, **dadurch gekennzeichnet, daß** Lichtquelle (4), Bildschirm (2) und optische Baugruppe (8) zu einem Belichtungskopf (9) zusammengefaßt sind, der verfahrbar ausgebildet ist.

27. Vorrichtung nach Anspruch 26, **dadurch gekennzeichnet, daß** mindestens ein Antrieb zur Erzeugung einer Relativbewegung zwischen Belichtungskopf (9) und Musterträger (1) als Linearantrieb (34, 35, 39, 40) ausgebildet ist.

28. Vorrichtung nach einem der Ansprüche 17 bis 27, **dadurch gekennzeichnet, daß** der Belichtungskopf (9) optische Elemente (6, 7, 8, 44) aufweist, die aus Quarzglas bestehen.

29. Vorrichtung nach einem der Ansprüche 26 bis 28, **dadurch gekennzeichnet, daß** mehrere Belichtungsköpfe (9) auf einer Achse angeordnet sind.

30. Vorrichtung nach Anspruch 29, **dadurch gekennzeichnet, daß** jedem Belichtungskopf (9) ein eigener Linearantrieb (39, 40) zugeordnet ist und für die andere Achse ein gemeinsamer Linearantrieb (34, 35) für alle Belichtungsköpfe (9) vorgesehen ist.

31. Vorrichtung nach einem der Ansprüche 17 bis 30, **dadurch gekennzeichnet, daß** die optische Baugruppe (8) als Spiegelsystem ausgebildet ist.

32. Vorrichtung nach einem der Ansprüche 17 bis 31, **dadurch gekennzeichnet, daß** der Flüssigkristallbildschirm (2) als ein aktiver Flüssigkristallbildschirm ausgebildet ist.

33. Vorrichtung nach einem der Ansprüche 17 bis 32, **dadurch gekennzeichnet, daß** der Strahlengang, vorzugsweise mittels eines Spiegels (10), lenkbar ausgebildet ist.

34. Vorrichtung nach einem der Ansprüche 17 bis 33, **dadurch gekennzeichnet, daß** der Musterträger (11) gekrümmt ausgebildet ist.

35. Vorrichtung nach einem der Ansprüche 17 bis 34, **dadurch gekennzeichnet, daß** der Flüssigkeitsbildschirm (2) als Belichtungsverschluß wirkend ausgebildet ist.

36. Vorrichtung nach einem der Ansprüche 17 bis 35, **dadurch gekennzeichnet, daß** sie einen Aufspanntisch (13) für Musterträger aufweist, der als Saugtisch ausgebildet ist.

## Claims

1. A method of photomechanical production of structured surfaces on a pattern carrier (1) as an image of an electronically stored original, in particular for exposure of offset printing plates, by breaking down the original into partial images by electronic means and representing the partial images in succession on a liquid crystal display screen (2) and imaging them on a pattern carrier (1) in such a way that the images are recombined to form an overall image of the original on the pattern carrier (1), **characterized in that** the image content of each partial image is checked by an analyzer circuit or software to determine whether it contains image information, and the partial image is imaged on the pattern carrier (1) as a function of the results of this check.

2. A method according to claim 1, **characterized in that** a first data record for its image content and a second data record for the position of the image are assigned to each partial image, and only data records having an image content belonging together are used to generate a sequence of control data records for transfer to a numeric control.

3. A method according to claim 2, **characterized in that** the quantity of second data records is sorted so as to yield the lowest possible sum of individual distances between the positions of the partial images, and the data records are transferred in this order to the numeric control.

4. A method according to claims 1, 2 or 3, **characterized in that** at least one electric linear drive (34, 35, 39, 40) is used to produce a relative movement between the pattern carrier (1) and the liquid crystal display screen (2).

5. A method to claims 1, 2, 3 or 4, **characterized in that** before each imaging of a partial image, the distance between the liquid crystal display screen (2) and the pattern carrier (1) is measured, and deviations from a preset value are corrected automatically.

6. A method according to claims 1, 2, 3, 4 or 5, **characterized in that** in order to image a light source (4), its light flux is measured and deviations from a predetermined light flux are corrected automatically.

7. A method according to claim 6, **characterized in that** the correction is made by varying the exposure time.

8. A method according to claim 6, **characterized in that** the correction is made by varying an electric power supply to the light source (4).

9. A method according to one of the preceding claims, **characterized in that** the liquid crystal display screen (2) is imaged on an altered scale, preferably a reduced scale.

10. A method according to one of the preceding claims, **characterized in that** the partial images are positioned with an accuracy of better than 5 µm, particular better than 2 µm.

11. A method according to one of the preceding claims, **characterized in that** several partial images are imaged at the same time.

12. A method according to claim 11, **characterized in that** multiple images are in synchronized motion relative to the pattern carrier (1).

13. A method according to claim 11 or 12, **characterized in that** the distance between two images exposed at the same time can be varied.

14. A method according to one of the preceding claims, **characterized in that** the light flux is switched by means of a shutter (18), preferably in rotation about an axis of rotation perpendicular to the path of the beam.

15. A method according to one of the preceding claims, **characterized in that** the partial image is produced by means of a raster image processor according to a frequency raster method.

16. A method according to one of the preceding claims, **characterized in that** the partial images are imaged so that they overlap.

17. A device for exposing photo-sensitive printing plates with a light source (4), a digitally stored original and a pattern carrier (1), where the original can be imaged on the pattern carrier (1) in the form of partial images on a liquid crystal display screen (2), by means of an optical module (8) which is disposed in the path of the beam, where the image and the pattern carrier (1) are designed so they can be moved relative to one another in at least one axis, **characterized in that** a measurement and control device (28) is provided for measuring and controlling the distance between the liquid crystal display screen (2) or an exposure head (9) and the pattern carrier (1) for each partial image.

18. A device according to claim 17, **characterized in that** a sensor (17, 24) is provided for measuring the light flux, and a control circuit (30, 33) is provided for correcting deviations in light flux from a setpoint.

19. A device according to claim 17 or 18, **characterized in that** a control device for varying an exposure time is provided in the control circuit (30).

20. A device according to claim 17, 18 or 19, **characterized in that** a control device for varying the light flux is provided in the control circuit (33).

21. A device according to claim 17, 18, 19 or 20, **characterized in that** a shutter (18) for switching the light flux is provided.

22. A device according to claim 21, **characterized in that** the shutter (18) is designed as a rotating body (54) with an axis of rotation which is essentially perpendicular to the path of the beam.

23. A device according to claim 22, **characterized in that** the rotating body (54) is designed partially as a cylinder with cutouts.

24. A device according to claim 22 or 23, **characterized in that** a brushless d.c. drive is provided as the drive (53) for the shutter.

25. A device according to one of claims 17 through 24, **characterized in that** a polarization filter (16), which is designed to be separate from the display screen (2), is provided for the display screen (2).

26. A device according to one of claims 17 through 25, **characterized in that** the light source (4), the display screen (2) and the optical module (8) are combined in one exposure head (9) which is designed to be movable.

27. A device according to claim 26, **characterized in that** at least one drive is designed as a linear drive (34, 35, 39, 40) for producing a relative motion between the exposure head (9) and the pattern carrier (1).

28. A device according to one of claims 17 through 27, **characterized in that** the exposure head (9) has optical elements (6, 7, 8, 24) which are made of quartz glass.

29. A device according to one of claims 26 through 28, **characterized in that** several exposure heads (9) are arranged on one axis.

30. A device according to claim 29, **characterized in that** each exposure head (9) is assigned its own linear drive (39, 40), and a common linear drive (34, 35) is provided for all the exposure heads (9) for the other axis.

31. A device according to one of claims 17 through 30, **characterized in that** the optical module (8) is designed as a mirror system.

32. A device according to one of claims 17 through 31, **characterized in that** the liquid crystal display screen (2) is designed as an active liquid crystal display screen.

33. A device according to one of claims 17 through 32, **characterized in that** the path of the beam is designed so that it can be deflected, preferably by means of a mirror (10).

34. A device according to one of claims 17 through 33, **characterized in that** the pattern carrier (11) is designed to have a curvature.

35. A device according to one of claims 17 through 34, **characterized in that** the liquid crystal display screen (2) is designed so that it acts as an exposure shutter.

36. A device according to one of claims 17 through 35, **characterized in that** it has a clamping table (13) for pattern carriers, said table being designed as a suction table.

## Revendications

1. Procédé d'élaboration photomécanique de surfaces structurées sur un support d'épreuve (1), consistant en une reproduction d'un modèle enregistré sur mémoire numérique, en particulier pour l'exposition de plaques d'impression offset, le modèle étant divisé, par méthode électronique, en images partielles et les images étant affichées l'une après l'autre sur un écran à cristaux liquides (2) et reproduites sur le support d'épreuve (1) de sorte que les images reportées se regroupent pour reformer une image complète du modèle sur le support d'épreuve (1), **caractérisé en ce que**, par un branchement ou par un logiciel d'évaluation, le contenu graphique de chaque image partielle soit vérifié pour contrôler s'il contient des informations graphiques, une reproduction de l'image partielle sur le support d'épreuve (1) étant réalisée en fonction de ce contrôle.

2. Procédé selon la revendication 1, **caractérisé en ce qu'**à chaque image est associé un premier enregistrement pour son contenu graphique et un deuxième enregistrement pour sa position et que seules les enregistrements allant ensemble et ayant un contenu graphique sont utilisés pour l'élaboration d'une série d'enregistrements de commande à transmettre à une commande numérique.

3. Procédé selon la revendication 2, **caractérisé en ce que** l'ensemble du deuxième enregistrement est trié de sorte que le nombre d'écarts isolés entre les positions des images partielles soit le plus réduit possible et que les enregistrements soient transmis dans cet ordre à la commande numérique.

4. Procédé selon la revendication 1, 2 ou 3, **caractérisé en ce qu'**on utilise au moins une transmission linéaire électrique (34, 35, 39, 40) comme entraînement pour provoquer un mouvement relatif entre le support d'épreuve (1) et l'écran à cristaux liquides (2).

5. Procédé selon la revendication 1, 2, 3 ou 4, **caractérisé en ce qu'**au moins une mesure de l'écart entre l'écran à cristaux liquides (2) et le support d'épreuve (1) est réalisée avant chaque reproduction d'image partielle et que les écarts par rapport à une valeur prédéterminée sont corrigés automatiquement.

6. Procédé selon la revendication 1, 2, 3, 4 ou 5, **caractérisé en ce qu'**on utilise pour la reproduction une source lumineuse (4) dont le flux lumineux est mesuré et que les écarts par rapport à un flux lumineux prédéterminé sont corrigés automatiquement.

7. Procédé selon la revendication 6, **caractérisé en ce que** la correction est faite en modifiant le temps d'exposition.

8. Procédé selon la revendication 6, **caractérisé en ce que** la correction est faite en modifiant l'alimentation électrique de la source lumineuse (4).

9. Procédé selon une des revendications précédentes, **caractérisé en ce que** l'écran à cristaux liquides (2) est reproduit à une échelle différente, de préférence en réduction.

10. Procédé selon une des revendications précédentes, **caractérisé en ce que** le positionnement des images partielles se fait avec une précision supérieure à 5 µm, en particulier supérieure à 2 µm.

11. Procédé selon une des revendications précédentes, **caractérisé en ce que** plusieurs images partielles sont reproduites simultanément.

12. Procédé selon la revendication 11, **caractérisé en ce qu'**un mouvement relatif synchrone de plusieurs images reproduites a lieu en direction du support d'épreuve (1).

13. Procédé selon la revendication 11 ou 12, **caractérisé en ce que** l'écart entre deux images reportées exposées en même temps peut être modifié.

14. Procédé selon une des revendications précédentes, **caractérisé en ce que** le flux lumineux est actionné grâce à un obturateur (18), qui tourne, de préférence, autour d'un axe rotatif perpendiculaire au rayonnement.

15. Procédé selon une des revendications précédentes, **caractérisé en ce que** l'image partielle est créée grâce à un processeur d'images tramées selon un procédé de tramage fréquentiel.

16. Procédé selon une des revendications précédentes, **caractérisé en ce que** les images sont reproduites avec un recouvrement mutuel.

17. Procédé d'exposition de plaques d'impression sensibles à la lumière avec une source lumineuse (4), un modèle enregistré sur mémoire numérique et un support d'épreuve (1), le modèle pouvant être affiché sous forme d'images partielles sur un écran à cristaux liquides (2), reproductible, grâce à un agrégat optique (8) installé dans l'axe du rayonnement, sur le support d'épreuve (1), l'image reportée et le support d'épreuve (1) étant mobiles l'un par rapport à l'autre sur au moins un axe, **caractérisé en ce qu'**un dispositif de réglage (28) est prévu, pour chaque image partielle, pour la mesure et le réglage de l'écart entre l'écran à cristaux liquides (2) ou une tête d'exposition (9) et le support d'épreuve (1).

18. Dispositif selon la revendication 17, **caractérisé en ce qu'**un capteur (17, 24) pour la mesure du flux lumineux et une boucle d'asservissement (30, 33) pour la correction d'écarts du flux lumineux par rapport à une valeur théorique sont prévus.

19. Dispositif selon la revendication 17 ou 18, **caractérisé en ce que** la boucle d'asservissement (30) comporte un dispositif modulateur pour modifier le temps d'exposition.

20. Dispositif selon la revendication 17, 18 ou 19, **caractérisé en ce que** la boucle d'asservissement (33) comporte un dispositif modulateur pour actionner le flux lumineux.

21. Dispositif selon la revendication 17, 18, 19 ou 20, **caractérisé en ce qu'**un obturateur (18) est prévu pour actionner le flux lumineux.

22. Dispositif selon la revendication 21, **caractérisé en ce que** l'obturateur (18) est conçu sous forme d'un corps rotatif (54), avec un axe de rotation, qui est positionné essentiellement à la perpendiculaire du rayonnement.

23. Dispositif selon la revendication 22, **caractérisé en ce que** le corps rotatif (54) consiste partiellement en un cylindre à segments.

24. Dispositif selon la revendication 22 ou 23, **caractérisé en ce que** l'entraînement (53) de l'obturateur est assuré par une transmission à courant continu sans balais.

25. Dispositif selon une des revendications 17 à 24, **caractérisé en ce qu'**est associé à l'écran (2) un filtre à polarisation (16), qui est distinct de l'écran (2).

26. Dispositif selon une des revendications 17 à 25, **caractérisé en ce que** la source lumineuse (4), l'écran (2) et l'agrégat optique (8) sont regroupés pour former une tête d'exposition (9), qui peut être déplacée.

27. Dispositif selon la revendication 26, **caractérisé en ce qu'**au moins un entraînement produisant un mouvement relatif entre la tête d'exposition (9) et le support d'épreuve (1) est un entraînement linéaire (34, 35, 39, 40).

28. Dispositif selon une des revendications 17 à 27, **caractérisé en ce que** la tête d'exposition (9) présente des éléments optiques (6, 7, 8, 44) fabriqués en verre quartzeux.

29. Dispositif selon une des revendications 26 à 28, **caractérisé en ce que** plusieurs têtes d'exposition (9) sont montées sur un axe.

30. Dispositif selon la revendication 29, **caractérisé en ce qu'**un entraînement linéaire propre (39, 40) est associé à chaque tête d'exposition (9) et que, pour l'autre axe, un entraînement linéaire commun (34, 35) à toutes les têtes d'exposition (9) est prévu.

31. Dispositif selon une des revendications 17 à 30, **caractérisé en ce que** l'agrégat optique (8) se présente sous forme de système réfléchissant.

32. Dispositif selon une des revendications 17 à 31, **caractérisé en ce que** l'écran à cristaux liquides (2) est un écran à cristaux liquides de type actif.

33. Dispositif selon une des revendications 17 à 32, **caractérisé en ce que** le rayonnement est orientable, de préférence au moyen d'un miroir (10).

34. Dispositif selon une des revendications 17 à 33, **caractérisé en ce que** le support d'épreuve (11) est de forme courbée.

35. Dispositif selon une des revendications 17 à 34, **caractérisé en ce que** l'écran à cristaux liquides (2) a une fonction d'obturateur d'exposition.

36. Dispositif selon une des revendications 17 à 35, **caractérisé en ce qu'**il comporte une table de tension (13) pour le support d'épreuve qui a une fonction de table d'aspiration.
